# FASCICULE DE BREVET EUROPEEN

(11) **EP 3 516 408 B1**
(45) Date de publication et mention de la délivrance du brevet: **15.12.2021**
(21) Numéro de dépôt: 17752408.9
(22) Date de dépôt: 22.08.2017
(51) Int. Cl.: G01R 33/00, G01R 33/04

(54) **SYSTÈME PENDULAIRE ET PROCÉDÉ DE FABRICATION D'UN TEL SYSTÈME**
PENDELSYSTEM UND VERFAHREN ZUR HERSTELLUNG EINES SOLCHEN SYSTEMS
PENDULUM SYSTEM AND METHOD OF FABRICATING SUCH A SYSTEM

(30) Priorité: 20.09.2016 FR 1658800
(43) Date de publication de la demande: 31.07.2019
(73) Titulaire: SAFRAN ELECTRONICS & DEFENSE, 75015 Paris (FR)
(72) Inventeur: BAUDET, Yannick, 77550 Moissy-Cramayel (FR); MERLET, Etienne, 77550 Moissy-Cramayel (FR); JEAN, Fabrice, 77550 Moissy-Cramayel (FR); DESROCHES, Laurent, 77550 Moissy-Cramayel (FR); MAGALHAES, Mickaël, 77550 Moissy-Cramayel (FR)
(74) Mandataire: Lavialle, Bruno François Stéphane
(86) Numéro de dépôt international: PCT/EP2017/071164
(87) Numéro de publication internationale: WO 2018/054637

(56) Documents cités:
- CN-U- 203 041 781
- DE-U- 20 008 753
- FR-A1- 2 238 162
- FR-A1- 2 974 420
- JP-U- H0 576 494
- JP-U- H0 634 580
- US-A- 1 258 280

## Description

La présente invention concerne un système pendulaire comme par exemple et de manière non limitative un dispositif à magnétomètres, et plus particulièrement une vanne de flux (ou « fluxgate » en anglais).

L'invention a également pour objet un procédé de fabrication d'un tel système pendulaire.

### ARRIERE-PLAN TECHNOLOGIQUE DE L'INVENTION

Une vanne de flux est un dispositif de mesure du champ magnétique terrestre permettant de déterminer l'orientation du chàmp magnétique terrestre par rapport à un axe de référence.

Lorsque la vanne de flux est montée sur un aéronef, l'axe de référence est aligné avec l'axe de déplacement de l'aéronef de sorte que la vanne de flux permet de déterminer le cap magnétique de l'aéronef.

Une vanne de flux comporte deux magnétomètres uni-axiaux disposés perpendiculairement l'un à l'autre dans un plan sensiblement horizontal.

Chaque magnétomètre comprend un noyau en matériau à haute perméabilité magnétique choisi de telle manière que le champ magnétique terrestre suffise pour amener le noyau dans un état proche de son état de saturation. Les noyaux sont entourés par un enroulement primaire et par un enroulement secondaire. L'enroulement primaire est alimenté par un courant alternatif pour engendrer dans le noyau une variation de champ magnétique qui produit lui-même une différence de potentiels aux bornes de l'enroulement secondaire. Le traitement du signal qui apparaît sur l'enroulement secondaire permet la détermination très précise de la composante du champ magnétique dans la direction des bobines concernées.

Pour soustraire les magnétomètres à la composante verticale du champ magnétique terrestre, il est nécessaire de maintenir les magnétomètres dans un plan le plus horizontal possible. A cette fin les noyaux sont montés sur un pendule suspendu sous une platine. Les enroulements des magnétomètres sont alors raccordés par des fils à un connecteur monté au centre de cette platine.

Afin de protéger lesdits fils, notamment lors d'un fort débattement du pendule, il est connu de rassembler les fils entre eux afin de former une torsade remontant du pendule jusqu'au connecteur mais ceci oblige toutefois à avoir une vanne de flux relativement lourde pour obtenir une bonne robustesse de la connexion électrique sans interaction sur l'équilibre du pendule, la vanne de flux étant en outre encombrante.

Le document FR2974420A1 décrit un système pendulaire dans lequel un ensemble magnétométrique est relié à un connecteur monté sur une platine par des fils rassemblés en une torsade. Ladite torsade est conformée en forme spiralée.

### BUT DE L'INVENTION

Un but de l'invention est de fournir un moyen permettant d'avoir un système pendulaire de masse et de dimensions réduites.

### BREVE DESCRIPTION DE L'INVENTION

A cet effet, l'invention concerne un système pendulaire comprenant un pendule relié à un connecteur, le système comprenant des fils de raccordement du pendule au connecteur qui sont rassemblés en une torsade, la torsade présentant une portion centrale en spirale conformée généralement en un cône dont un sommet est raccordé au connecteur pour être la partie de la spirale la plus proche d'un point de pivotement du pendule.

De par la forme spiralée conique de la torsade, il est ainsi possible d'avoir un système pendulaire présentant une masse relativement réduite et un encombrement peu important en réduisant la hauteur occupée par la torsade qui peut être de grande longueur, sans risque d'interférence entre les spires du cône et ce même en cas de débattement important du pendule.

De façon avantageuse, ceci permet en outre d'assurer une connexion souple et endurante entre le connecteur et le pendule et d'éviter notamment une rupture de l'un des fils ou un décalage de la position d'équilibre du pendule.

Selon un mode de réalisation particulier de l'invention, la spirale présente une structure homogène lorsque le pendule est au repos.

Selon un mode de réalisation particulier de l'invention, la spirale conique ne présente pas de changement d'angularité sur sa longueur.

Selon un mode de réalisation particulier de l'invention, la spirale présente un nombre entier de spires.

Selon un mode de réalisation particulier de l'invention, la torsade est elle-même conformée de sorte à présenter une structure homogène.

Selon un mode de réalisation particulier de l'invention, le nombre de tours de vrillage de la torsade est homogène sur toute la longueur de la torsade.

Selon un mode de réalisation particulier de l'invention, la torsade est conformée de sorte que le nombre de tours de vrillage de la torsade est un nombre entier.

Selon un mode de réalisation particulier de l'invention, la torsade a une portion d'extrémité noyée dans un bloc qui est solidaire du connecteur.

Selon un mode de réalisation particulier de l'invention, une portion libre d'extrémité de la torsade solidaire du connecteur est agencée sensiblement au niveau du point de pivotement du pendule.

Selon un mode de réalisation particulier de l'invention, le système pendulaire comprend un bloc solidaire du connecteur qui emprisonne une zone de connexion des fils aux broches du connecteur.

Selon un mode de réalisation particulier de l'invention, la spirale a une portion d'extrémité solidarisée au pendule de sorte qu'une extrémité de la spirale soit sensiblement tangente à un plan formé par une base du pendule.

Selon un mode de réalisation particulier de l'invention, la torsade est solidarisée au pendule en deux points.

L'invention concerne également un procédé de fabrication d'un système pendulaire tel que précédemment cité comportant les étapes de :
- solidariser chacun des fils de raccordement à une extrémité au connecteur afin de constituer un faisceau de fils de même longueur,
- conformer la partie centrale du faisceau de fils en une torsade homogène sur toute sa longueur,
- solidariser l'extrémité de la torsade au connecteur afin de s'assurer qu'il n'y ait pas de portion libre de fils non torsadé,
- conformer la portion centrale de la torsade en une spirale conique,
- solidariser la base de la spirale au pendule, et s'assurer que le sommet ne forme pas d'angle droit avec le reste de la spirale.

D'autres caractéristiques et avantages de l'invention ressortiront à la lecture de la description qui suit d'un mode de réalisation particulier non limitatif de l'invention.

### BREVE DESCRIPTION DES FIGURES

Il sera fait référence aux dessins annexés, parmi lesquels :
- la figure 1 est une vue en coupe axiale d'un système pendulaire conforme à un mode de réalisation particulier de l'invention,
- la figure 2 est une vue en perspective d'un outil de conformation d'une torsade du système pendulaire illustré à la figure 1.

### DESCRIPTION DETAILLEE DE L'INVENTION

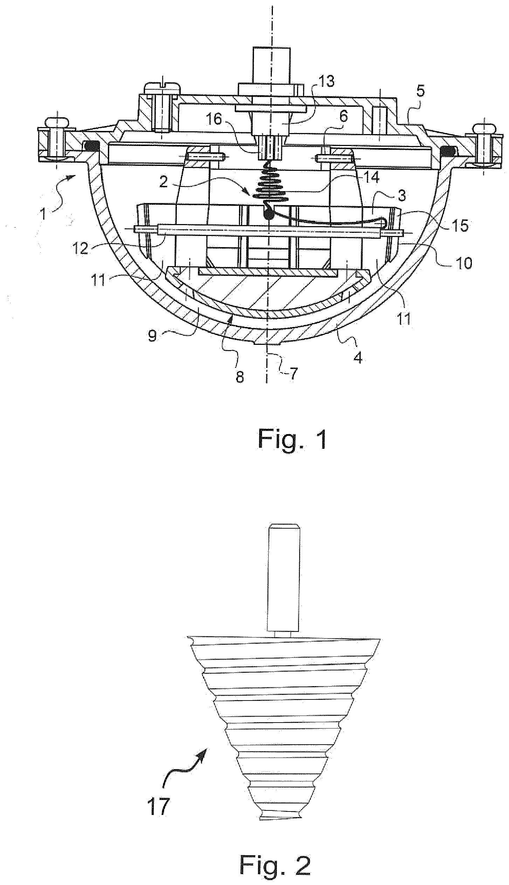

En référence à la figure 1, le système pendulaire selon un mode de réalisation particulier de l'invention est ici une vanne de flux. Cette application n'est bien sûr pas limitative et le système pendulaire pourra par exemple être un autre dispositif à magnétomètres.

La vanne de flux comprend typiquement un boîtier, généralement désigné en 1, contenant un ensemble électromagnétique 2 de détection de champ magnétique et un pendule 3 qui est suspendu dans le boîtier et qui supporte l'ensemble électromagnétique 2.

Le boîtier 1 comprend une paroi 4 en forme de calotte sphérique permettant le débattement du pendule 3, et ayant un bord circulaire délimitant une ouverture obturée par une platine 5 de fixation de la vanne à un support.

Le pendule 3 est suspendu à la platine 5 par une articulation double 6 comportant un anneau relié à la platine 5 pour pivoter autour d'un premier axe et relié au pendule 3 pour pivoter autour d'un deuxième axe perpendiculaire au premier axe et coplanaire à celui-ci. Les moyens de liaison de l'anneau à la platine 5 comprennent deux liaisons pivots à centrage court et les moyens de liaison de l'anneau au pendule 3 comprennent également deux liaisons pivots à centrage court. Pour chaque axe, chaque liaison pivot comprend un tourillon ayant une extrémité moletée encastrée dans le pendule ou la platine et une extrémité opposée reçue librement via un ajustement glissant dans un perçage réalisé dans l'anneau. L'encastrement de la partie moletée pourra être renforcé par collage. La portée de l'ajustement est réduite au maximum pour éviter qu'une déformation des pièces induisant un désalignement des tourillons n'engendre des contraintes préjudiciables au mouvement du pendule. En variante, les liaisons pivots peuvent être remplacées par des liaisons rotules pour limiter encore les contraintes qui pourraient résulter d'un mauvais alignement des tourillons, cette variante étant cependant plus coûteuse. L'articulation double 6 autorise un débattement angulaire du pendule 5 de 30° environ de part et d'autre d'un troisième axe normal à la platine et sécant du premier axe et du deuxième axe.

Le pendule 3 incorpore une masse équilibrée de telle manière qu'au repos, la platine étant horizontale, un axe 7 passant par le centre de gravité du pendule et l'intersection des axes de pivotement du pendule 3 soit normal à la platine 5 (soit le point de pivotement du pendule 3).

Le pendule 3 comprend en regard de la paroi 4 une surface 8 en calotte sphérique centrée sur l'axe 7. La surface 8 délimite avec la paroi 4 un espace de laminage 9. La surface 8 est entourée d'une portion annulaire de surface 10 en retrait et est percée, au voisinage de son pourtour, d'ouvertures 11 traversantes.

De préférence, le pendule est réalisé en matériau thermoplastique, ici non chargé pour favoriser la précision et la stabilité géométrique en température des surfaces sphériques, et incorpore un insert, par exemple en métal, formant une masse inertielle. Le pendule est avantageusement fabriqué dans ce cas par injection du matériau thermoplastique dans un moule de manière à surmouler le matériau thermoplastique sur l'insert. Ce mode de fabrication permet de : limiter les opérations d'assemblage ; obtenir un pendule présentant une surface extérieure relativement lisse favorable à la réalisation de l'amortissement laminaire ; optimiser le positionnement relatif du centre d'inertie du pendule, du centre de rotation du pendule et du centre de la calotte. Le matériau thermoplastique choisi est par exemple un polyéther imide (PEI).

Un liquide d'amortissement emplit une partie du boîtier 1, ici jusqu'au bord supérieur du pendule 3.

L'espace de laminage 9 reçoit ainsi du liquide d'amortissement de telle manière que le liquide d'amortissement soit laminé entre la surface 8 et la paroi 4. La portion annulaire de surface en retrait 10 définit avec la paroi 4 un genre d'entonnoir favorisant la pénétration du liquide d'amortissement dans l'espace de laminage 9.

Le rayon du pendule 3 et de la surface interne de la paroi 4 du boîtier 1 définissant l'épaisseur de l'espace de laminage 9 sont déterminés en appliquant par exemple la théorie du viscosimètre de Couette.

Le liquide d'amortissement retenu est une huile ayant une viscosité cinématique de 5 mm²/s à 25°C, une densité voisine de 0,91 à 25°C, un point de congélation à -65°C.

L'épaisseur de l'espace de laminage 9 résulte d'un compromis tenant compte de la viscosité du liquide d'amortissement et du procédé de fabrication choisi. En effet, dans l'hypothèse où une fabrication en matériaux thermoplastiques injectés est choisi, l'épaisseur minimale qu'il est possible d'obtenir dépendra de la réalisation ou non d'une reprise d'usinage.

L'ensemble électromagnétique 2 comprend des magnétomètres 12 uni-axiaux, connus en eux-mêmes, comprenant des noyaux en un matériau ferromagnétique ayant une haute perméabilité magnétique et réagissant aux champs magnétiques de faible intensité. Le matériau ferromagnétique employé ici est plus particulièrement un alliage de fer et de nickel. Chaque noyau comprend ici des bandes dudit matériau qui sont fixées dans un tube de verre.

Deux enroulements superposés entourent le tube de verre, l'enroulement primaire et l'enroulement secondaire du magnétomètre.

Les magnétomètres 12 s'étendent à 90° l'un par rapport à l'autre et l'un au-dessus de l'autre parallèlement au premier axe et au deuxième axe de l'articulation double 6. Les magnétomètres 12 sont écartés l'un de l'autre pour éviter un couplage magnétique entre eux. Les magnétomètres 12 ont leurs extrémités fixées dans des encoches périphériques 15 du pendule 3 de telle manière que, lorsque le pendule 3 est laissé libre de penduler et au repos, les magnétomètres 12 soient horizontaux.

Le boîtier comprend un connecteur 13. Le connecteur 13 est monté au centre de la platine 5. Le connecteur 13 est par exemple un connecteur de type micro connecteur cylindrique étanche à 8 broches.

Les enroulements des magnétomètres sont reliés au connecteur 13 à l'aide de fils.

Ces fils sont torsadés ensemble pour former une torsade 14 reliant les enroulements au connecteur 13.

La torsade 14 forme dans sa portion centrale une spirale généralement conformée en un cône dont le sommet est raccordé au connecteur 13 pour être la partie de la spirale la plus proche du point de pivotement du pendule 3, la base du cône étant alors raccordée aux enroulements. Le sommet est donc la partie de la spirale la plus proche du connecteur 13. La torsade 14 dessine ainsi plusieurs spires de diamètre de plus en plus important à mesure que l'on s'éloigne du connecteur 13 pour atteindre les enroulements.

La spirale conique ainsi formée est conformée de telle manière que la spirale conique n'entrave pas les mouvements du pendule. En particulier, la spirale conique est disposée pour s'étendre sensiblement autour de l'axe 7 (la hauteur du cône s'étendant le long dudit axe 7), le pendule 3 étant au repos et la platine 5 horizontale, de manière à minimiser son influence sur le balancement du pendule 3, au point de la rendre négligeable vis-à-vis de l'effet de la gravité.

Par ailleurs, la spirale conique est conformée de sorte que les spires ne puissent s'accrocher entre elles même pendant un fort débattement du pendule 3.

La spirale conique ainsi conformée présente une structure homogène lorsque le pendule 3 est au repos (c'est-à-dire que le pas de la spirale est régulier, l'augmentation du diamètre des spires entre deux spires consécutives est régulier ...) En particulier, la spirale conique ne présente pas de changement d'angularité sur sa longueur : la spirale conique est ainsi continue. Par ailleurs la spirale présente ici un nombre entier de spires.

De manière générale, la torsade 14 elle-même est conformée de sorte à présenter une structure homogène.

Ainsi, le nombre de tours de vrillage de la torsade 14 est homogène sur toute la longueur de la torsade 14 (étant rappelé qu'à un tour de vrillage correspond une torsion à 360 degrés des fils rassemblés entre eux). Par ailleurs la torsade présente ici un nombre entier de tours de vrillage.

Un ordre de grandeur est typiquement une moyenne de 3 à 5 tours de vrillage par spire de la spirale conique, pour 4 à 6 spires.

De par le vrillage, la torsade 14 présente une cohésion de l'ensemble de ses fils de sorte que les fils restent bien plaqués les uns contre les autres sans qu'un des fils ne dépasse localement du reste de la torsade 14.

Afin d'aligner l'effort de traction de la torsade sur un rayon du mouvement de rotation du pendule 3 pour ne pas induire de couple de rotation sur le pendule 3 et plus généralement d'éviter que l'effort de traction exercé sur le pendule 3 par la torsade 14 soit variable en fonction du décalage angulaire du pendule 3, le sommet de la spirale est agencé sensiblement au niveau du point de pivotement du pendule 3.

Par ailleurs, toujours afin d'augmenter la résistance mécanique de la liaison des fils au connecteur 13, la torsade 14 ne forme pas un angle droit avec le sommet du cône pour son attachement au connecteur 13. En effet, le sommet du cône s'étend ici jusqu'au connecteur et ce de manière continue au reste de la spirale. Le début de la spirale s'étend donc obliquement à l'axe 7 et non selon l'axe 7.

La torsade 14 a une portion d'extrémité noyée dans un bloc 16 qui est solidaire du connecteur 13 et qui emprisonne également la zone de connexion des fils aux broches du connecteur 13. Le bloc 16 est par exemple en résine ou encore en colle.

Le bloc 16 permet d'augmenter la résistance mécanique de la liaison des fils au connecteur 13 et plus généralement d'éviter qu'un effort de traction exercé sur la torsade 14 engendre une contrainte importante sur les fils individuellement ou sur leur liaison au connecteur.

Le bloc 16 est conformé de sorte à s'étendre depuis le connecteur 13 jusqu'au niveau sensiblement du point d'intersection des axes de pivotement du pendule 3 toujours dans une optique d'augmentation de la résistance mécanique de la liaison des fils au connecteur 13 et de stabiliser et de minimiser les efforts induits par la spirale au pendule 3. On note toutefois que le sommet du cône n'est pas nécessairement noyé dans le bloc 16. De la sorte la portion d'extrémité libre de la torsade 14 (correspondant à la portion de la torsade 14 débouchant du bloc 16) est agencée sensiblement au niveau du point de pivotement du pendule 3.

La torsade 14 a son autre portion d'extrémité solidarisée au pendule 3 au moyen d'au moins une goutte de colle. Ici la torsade 14 est solidarisée au magnétomètre 12 du pendule 3 qui se situe au-dessus de l'autre magnétomètre 12. De manière particulière, la torsade 14 forme un angle d'environ 90 degrés au niveau de son attachement au magnétomètre supérieur, sensiblement dans un plan perpendiculaire à l'axe 7, par le premier point de colle. La portion d'extrémité de la spirale solidarisée au pendule est ainsi tangente à un plan formé par une base du pendule 3 (qui est donc perpendiculaire à l'axe 7). La spirale présente ainsi une continuité géométrique, sans aucune angularité singulière, au niveau de son attachement au pendule 3 comme sur le reste de la spirale.

De préférence, la torsade 14 est solidarisée au magnétomètre 12 supérieur au moyen de deux points de colle afin d'assurer au mieux une parfaite régularité de la spirale. A partir du deuxième point de colle, les fils divergent de la torsade 14 pour rejoindre les enroulements.

Mis à part au niveau de ces deux points de colle et de la colle éventuellement utilisée pour le rattachement au connecteur 13, la torsade 14 ne présente aucune trace de colle le long de sa surface en particulier sur sa portion centrale généralement conformée en spirale conique.

On note que la portion centrale de la torsade 14 s'étend sur quasiment toute la longueur de la torsade 14, qui est ainsi conformée en spirale conique mis à part au niveau de sa première extrémité raccordée au connecteur 13 et de sa deuxième extrémité raccordée au magnétomètre supérieur 12. La portion centrale en spirale conique s'étend ainsi sensiblement du connecteur 13 au magnétomètre supérieur 12. Ladite portion centrale de la torsade 14 présente quant à elle une continuité géométrique, sans aucune angularité singulière, sur toute la longueur de la spirale et notamment au niveau de son attachement au pendule 3 comme au niveau de son attachement au connecteur 13.

Certaines étapes de la fabrication de la vanne de flux doivent être réalisées avec précaution.

La mise en place des magnétomètres 12 doit être réalisée avec beaucoup de précision et comprend trois étapes :
- positionner la platine 5 horizontalement et laisser le pendule 3 penduler jusqu'à ce qu'il se stabilise,
- positionner les extrémités des magnétomètres 12 dans les encoches du pendule 3 tout en maintenant dans une position horizontale les deux magnétomètres et, sans toucher le pendule 3,
- déposer une goutte de colle (la colle utilisée est une colle très fluide) simultanément dans les quatre encoches et faire polymériser la colle.

Ce mode de fabrication est particulièrement indiqué ici car il permet de s'affranchir des organes de réglage autrement nécessaires pour positionner horizontalement et fixer les magnétomètres. Or, de tels organes de réglage pourraient altérer le caractère laminaire de l'amortissement et constituent des éléments massifs déportés par rapport au centre de gravité du pendule. En outre, la suppression des organes de réglage rend la vanne de flux plus précis et robuste avec un risque de dérèglement dans le temps extrêmement limité.

La mise en place du raccordement des enroulements au connecteur 3 va être à présent décrite.

De manière connue en soi, les fils sont ici directement issus des enroulements et sont en outre solidarisés respectivement à l'une des broches du connecteur 3 par exemple par brasage.

On rassemble ensuite les fils vers le centre du connecteur et au plus près des broches. Ceci permettra de faciliter la réalisation de la torsade 14.

La bonne homogénéité de la torsade 14 impose des longueurs de fils identiques. Aussi, le cheminement vers le centre du connecteur 13 aura été pris en considération pour établir la longueur nécessaire de chacun des fils avant leur solidarisation aux broches.

On vient alors emprisonner la zone de connexion des fils aux broches du connecteur 13 et les fils ainsi rassemblés dans un premier bloc de colle, de résine ... qui englobe donc également une partie du connecteur 13.

Puis on torsade les fils ainsi rassemblés et solidarisés entre eux à une extrémité pour former la torsade 14.

On vient alors emprisonner le début de la torsade 14 dans le bloc général 16 qui est ici surmoulé en totalité sur le premier bloc de sorte à englober également une partie du connecteur 13 et la zone de connexion des fils aux broches du connecteur 13.

On vient ensuite solidariser la torsade 14 au magnétomètre supérieur à l'aide d'un point de colle (ce qui correspond ici au deuxième point de colle précitée à partir duquel les fils se séparent de la torsade 14).

Il faut alors conformer la torsade 14 en une spirale conique. A cet effet, on utilise une visseuse munie d'une vis 17 spiralée conique conformée pour former la spirale précitée (vis 17 illustrée à la figure 2).

A l'issue de cette étape, la torsade 14 présente la forme voulue. Il faut toutefois la solidariser de manière appropriée comme précité au magnétomètre 12 supérieur et au connecteur 13.

A cet effet, on commence d'abord par solidariser la base du cône au magnétomètre 12 supérieur à l'aide d'un point de colle (correspondant au premier point de colle précité) en s'assurant donc de la conformation sans angularité de la spirale à ce niveau.

Puis on solidarise le sommet du cône au connecteur 13 encore une fois à l'aide d'un point de colle afin de s'assurer que ce sommet ne forme pas d'angle avec le reste de la spirale conique.

Bien entendu, l'invention n'est pas limitée au mode de réalisation décrit mais englobe toute variante entrant dans le champ de l'invention telle que définie par les revendications.

En particulier, le boîtier et le pendule peuvent avoir une structure différente de celle décrite. Le boîtier peut avoir une forme extérieure différente de sa forme intérieure en calotte sphérique.

L'ensemble électromagnétique peut avoir une structure différente et comprendre un tore.

D'autres liquides d'amortissement peuvent être choisis avec des valeurs voisines de celles mentionnées.

Bien qu'ici la vanne de flux travaille en amortissement laminaire, le système pendulaire de l'invention pourra tout à fait être associé à une vanne de flux plus classique travaillant en amortissement volumique. L'amortissement n'est qu'optionnel, et le mode d'amortissement peut être différent que l'amortissement fluide mentionné.

Par ailleurs, l'ordre des étapes de raccordement des fils entre le connecteur d'une part et les enroulements d'autre part pourra être différent de ce qui a été indiqué.

## Revendications

1. Système pendulaire comprenant un pendule (3) relié à un connecteur (13), le système comprenant des fils de raccordement du pendule au connecteur qui sont rassemblés en une torsade (14), la torsade présentant une portion centrale en spirale conformée généralement en un cône dont un sommet est raccordé au connecteur pour être la partie de la spirale la plus proche d'un point de pivotement du pendule.

2. Système pendulaire selon la revendication 1 dans lequel la spirale présente une structure homogène en ce que l'augmentation du diamètre des spires entre deux spires consécutives de la spirale est régulière au repos, lorsque le pendule (3) est au repos.

3. Système pendulaire selon la revendication 1 ou la revendication 2, dans lequel la spirale ne présente pas de changement d'angularité sur sa longueur.

4. Système pendulaire selon la revendication 1 ou la revendication 2, dans lequel la spirale présente un nombre entier de spires.

5. Système pendulaire selon l'une des revendications précédentes, dans lequel la torsade (14) est elle-même conformée de sorte à présenter une structure homogène.

6. Système pendulaire selon la revendication 5, dans lequel le nombre de tours de vrillage de la torsade (14) est homogène sur toute la longueur de la torsade.

7. Système pendulaire selon la revendication 5 ou la revendication 6, dans lequel la torsade (14) est conformée de sorte que le nombre de tours de vrillage de la torsade est un nombre entier.

8. Système pendulaire selon l'une des revendications précédentes, dans lequel la torsade (14) a une portion d'extrémité noyée dans un bloc (16) qui est solidaire du connecteur (13).

9. Système pendulaire selon l'une des revendications précédentes, comprenant un bloc solidaire du connecteur (13) qui emprisonne une zone de connexion des fils aux broches du connecteur (13).

10. Système pendulaire selon l'une des revendications précédentes, dans lequel la torsade (14) a une portion d'extrémité solidarisée au pendule (3) de sorte qu'une extrémité de la spirale soit sensiblement tangente à un plan formé par une base du pendule.

11. Système pendulaire selon la revendication 10, dans lequel la torsade (14) est solidarisée au pendule (3) en deux points.

12. Procédé de fabrication d'un système pendulaire selon l'une des revendications précédentes, comportant les étapes de :
- solidariser chacun des fils de raccordement du pendule au connecteur à une extrémité au connecteur afin de constituer un faisceau de fils de même longueur,
- conformer la partie centrale du faisceau de fils en une torsade homogène sur toute sa longueur,
- solidariser l'extrémité de la torsade au connecteur afin de s'assurer qu'il n'y ait pas de portion libre de fils non torsadé,
- conformer la portion centrale de la torsade en une spirale conique,
- solidariser la base de la spirale au pendule, et s'assurer que le sommet ne forme pas d'angle droit avec le reste de la spirale.

## Patentansprüche

1. Pendelsystem, umfassend ein Pendel (3), das mit einem Stecker (13) verbunden ist, wobei das System Anschlussdrähte zum Anschließen des Pendels an den Stecker umfasst, die zu einer Verdrillung (14) zusammengefasst sind, wobei die Verdrillung einen spiralförmigen zentralen Abschnitt aufweist, der im Allgemeinen zu einem Kegel geformt ist, von dem eine Spitze an den Stecker angeschlossen ist, um der Teil der Spirale zu sein, der einem Drehpunkt des Pendels am nächsten ist.

2. Pendelsystem nach Anspruch 1, bei dem die Spirale eine homogene Struktur aufweist, insofern als die Zunahme des Durchmessers der Windungen zwischen zwei aufeinanderfolgenden Windungen der Spirale im Ruhezustand gleichförmig ist, wenn das Pendel (3) im Ruhezustand ist.

3. Pendelsystem nach Anspruch 1 oder Anspruch 2, bei dem die Spirale keine Winkeländerung über ihre Länge aufweist.

4. Pendelsystem nach Anspruch 1 oder Anspruch 2, bei dem die Spirale eine ganze Zahl von Windungen aufweist.

5. Pendelsystem nach einem der vorhergehenden Ansprüche, bei dem die Verdrillung selbst so geformt ist, dass sie eine homogene Struktur aufweist.

6. Pendelsystem nach Anspruch 5, bei dem die Anzahl der Verwindungsumdrehungen der Verdrillung (14) über die gesamte Länge der Verdrillung homogen ist.

7. Pendelsystem nach Anspruch 5 oder Anspruch 6, bei dem die Verdrillung (14) so ausgebildet ist, dass die Anzahl der Verwindungsumdrehungen der Verdrillung eine ganze Zahl ist.

8. Pendelsystem nach einem der vorhergehenden Ansprüche, bei dem die Verdrillung (14) einen Endabschnitt hat, der in einen Block (16) eingebettet ist, der fest mit dem Stecker (13) verbunden ist.

9. Pendelsystem nach einem der vorhergehenden Ansprüche, umfassend einen fest mit dem Stecker (13) verbundenen Block, der eine Verbindungszone der Drähte mit den Stiften des Steckers (13) einschließt.

10. Pendelsystem nach einem der vorhergehenden Ansprüche, bei dem die die Verdrillung (14) einen Endabschnitt hat, der fest mit dem Pendel (3) verbunden ist, derart, dass ein Ende der Spirale im Wesentlichen tangential zu einer durch eine Basis des Pendels gebildete Ebene ist.

11. Pendelsystem nach Anspruch 10, bei dem die Verdrillung (14) an zwei Punkten fest mit dem Pendel (3) verbunden ist.

12. Verfahren zum Herstellen eines Pendelsystems nach einem der vorhergehenden Ansprüche, umfassend die Schritte:
- Befestigen jedes der Anschlussdrähte zum Anschluss des Pendels am Stecker an einem Ende am Stecker, um ein Bündel von Drähten gleicher Länge zu bilden,
- Formen des zentralen Teils des Drahtbündels zu einer gleichförmigen Verdrillung über ihre gesamte Länge,
- Befestigen des Endes der Verdrillung am Stecker, um sicherzustellen, dass es keinen unverdrillten freien Drahtabschnitt gibt,
- Formen des zentralen Abschnitts der Verdrillung zu einer kegelförmigen Spirale,
- Befestigen der Basis der Spirale am Pendel und Sicherstellen, dass die Spitze keinen rechten Winkel mit dem Rest der Spirale bildet.

## Claims

1. A pendulum system comprising a pendulum (3) connected to a connector (13), the system comprising wires connecting the pendulum to the connector, which wires are connected together in a twisted cable (14), the twisted cable presenting a spiral central portion generally shaped as a cone having an apex connected to the connector so as to be the portion of the spiral that is closest to a pivot point of the pendulum.

2. A pendulum system according to claim 1, wherein the spiral presents a structure that is uniform as the increase in the diameter of the turns between two consecutive turns is regular at the rest, when the pendulum (3) is at rest.

3. A pendulum system according to claim 1 or claim 2, wherein the spiral does not present any change of angle along its length.

4. A pendulum system according to claim 1 or claim 2, wherein the spiral presents an integer number of turns.

5. A pendulum system according to any preceding claim, wherein the twisted cable (14) is itself shaped so as to present a structure that is uniform.

6. A pendulum system according to claim 5, wherein the number of twists of the twisted cable (14) is uniform over the entire length of the twisted cable.

7. A pendulum system according to claim 5 or claim 6, wherein the twisted cable (14) is shaped so that the number of twists in the twisted cable is an integer number.

8. A pendulum system according to any preceding claim, wherein the twisted cable (14) has an end portion embedded in a block (16) that is secured to the connector (13) .

9. A pendulum system according to any preceding claim, comprising a block secured to the connector (13) and holding captive a zone where the wires are connected to the pins of the connector (13).

10. A pendulum system according to any preceding claim, wherein the twisted cable (14) has an end portion secured to the pendulum (3) in such a manner that the end of the spiral is substantially tangential to a plane formed by the base of the pendulum.

11. A pendulum system according to claim 10, wherein the twisted cable (14) is secured to the pendulum (3) at two points.

12. A method of fabricating a pendulum system according to any preceding claim, the method comprising the steps of:
- securing each of the wires for connecting the pendulum to the connector at one end to the connector so as to constitute a bundle of same-length wires;
- shaping the central portion of the bundle of wires into a twisted cable that is uniform over its entire length;
- securing the end of the twisted cable to the connector so as to ensure that there is no non-twisted free wire portion at that end;
- shaping the central portion of the twisted cable into a conical spiral; and
- securing the base of the spiral to the pendulum, and ensuring that the apex does not form a right angle with the remainder of the spiral.
